# EUROPÄISCHE PATENTSCHRIFT

(11) **EP 2 616 287 B1**
(45) Veröffentlichungstag und Bekanntmachung des Hinweises auf die Patenterteilung: **02.03.2016**
(21) Anmeldenummer: 11751841.5
(22) Anmeldetag: 04.08.2011
(51) Int. Cl.: B60R 25/00, G07C 9/00

(54) **SENSOREINRICHTUNG FÜR EIN KRAFTFAHRZEUG**
SENSOR DEVICE FOR A VEHICLE
DISPOSITIF DE DÉTECTION POUR UN VÉHICULE

(30) Priorität: 13.09.2010 DE 102010037509
(43) Veröffentlichungstag der Anmeldung: 24.07.2013
(73) Patentinhaber: Huf Electronics GmbH, 42551 Velbert (DE)
(72) Erfinder: MÜLLER, Ulrich, 42549 Velbert (DE)
(74) Vertreter: Zenz Patentanwälte Partnerschaft mbB
(86) Internationale Anmeldenummer: PCT/EP2011/063441
(87) Internationale Veröffentlichungsnummer: WO 2012/034784

(56) Entgegenhaltungen:
- EP-A2- 0 770 749
- EP-A2- 1 970 265
- DE-A1- 10 106 400
- DE-A1-102008 063 366
- DE-B3-102005 032 402
- US-B1- 6 323 761

## Beschreibung

Die Erfindung betrifft eine Sensoreinrichtung zur Bedienkontrolle durch einen Benutzer zur Betätigung einer Funktion an einem Kraftfahrzeug. Insbesondere betrifft die Erfindung eine Sensoreinrichtung zur Erkennung von Betätigungsgesten, die von einem Benutzer des Kraftfahrzeuges zur Betätigung einer Funktion des Kraftfahrzeuges ausgeführt werden.

Sensoranordnungen sorgen zur Erhöhung der Sicherheit und des Bedienkomforts an zahlreichen Stellen von modernen Kraftfahrzeugen für eine Erkennung von Bedienerzugriffen. Beispielsweise verfügen zahlreiche Kraftfahrzeuge über Sensoranordnungen in den Türgriffen, um eine Annäherung eines Benutzers an den Türgriff zu erfassen und nach einer Überprüfung der Zugriffsberechtigung die Tür zu entsperren. Im Bereich der Heckklappen von Kraftfahrzeugen werden Sensoranordnungen eingesetzt, welche eine berührungslose Betätigung der Heckklappenöffnung ermöglichen. Dies ist insbesondere dann vorteilhaft, wenn ein Benutzer beispielsweise mit Ladegut belastet ist und eine händische Betätigung der Heckklappe nicht möglich ist. Der Benutzer kann dann z.B. mit den Beinen eine Bewegungsgeste im Bereich der Heckklappe, z.B. unterhalb des Stossfängers ausführen. Sensoranordnungen im Heckklappenbereich erfassen diese Bewegungsgeste und öffnen die Heckklappe, sofern die Geste als gültige Betätigungsgeste erkannt werden kann.

Die Bedienung mittels Gesten ist aus der EP 1 970 265 A2 bekannt. Eine Handgeste zum Ver- und Entsperren kann mittels mehrerer in eine Seitenscheibe eines Kraftfahrzeuges eingelassener kapazitiver Sensoren erkannt werden.

Da es jedoch in allen Bereichen der Kraftfahrzeugtechnik auf hohe Sicherheit und Vermeidung von möglichen Gefahrenquellen und Fehlerquellen ankommt, besteht jederzeit Bedarf für eine Reduzierung der Fehleranfälligkeit von Erkennungen eines Betätigungswillens. Beispielsweise sollten Alltagsereignisse ohne Betätigungswillen nicht fälschlicherweise als Betätigungswunsch erkannt werden, z.B. spielende Kinder, rollende Gegenstände, Tiere etc. Außerdem sollte die Erkennung robust bei wechselnden Umweltbedingungen reagieren.

Aufgabe der Erfindung ist es daher, eine Sensoranordnung mit verbesserter Erkennungsgenauigkeit bereitzustellen, um Betätigungsgesten eines Kraftfahrzeugbenutzers zu erkennen.

Zur Lösung dieser Aufgabe ist erfindungsgemäß eine Sensoreinrichtung mit den Merkmalen des Patentanspruchs 1 sowie ein Verfahren zur Auswertung von Sensorsignalen gemäß Patentanspruch 7 geeignet.

Gemäß der Erfindung weist die Sensoreinrichtung zur Erfassung von Betätigungsgesten eines Benutzers einen ersten kapazitiven Sensor zur Erfassung von Objekten in einem ersten Raumbereich und wenigstens einen weiteren kapazitiven Sensor zur Erfassung von Objekten in einem weiteren Raumbereich auf.

Die Raumbereiche der Erfassung des ersten Sensors und des zweiten Sensors können sich benachbart erstrecken oder überlappen sich teilweise.

Die Sensoren weisen Ausgänge auf, welche zum Abgriff von zeitlichen Signalverläufen der Sensoren geeignet sind.

Erfindungsgemäß wird also die Bewegungsgeste nicht mit einem einzigen Sensor erfasst, sondern eine Kombination von mehreren Sensoren mit jeweiligen, ggf. überlappenden Erfassungsbereichen wird eingesetzt. Des Weiteren werden zur Auswertung die zeitlichen Signalverläufe herangezogen, um den zeitlichen Ablauf der Geste in die Auswertung mit einzubeziehen.

Über die Einbeziehung eines Zeitverlaufs, welcher zur Ausführung einer Geste in dem entsprechenden Raumbereich erforderlich ist, kann die Erkennungsgenauigkeit gegenüber einer momentanen Auswertung deutlich erhöht werden. Die Geschwindigkeit, Verzögerungen und charakteristische Pausen geben ein für den Benutzer höchst individuelles Signal ab, welches außerdem Informationen über die sonstigen Charakteristika (Position und Erstreckung bzw. Ausdehnung des die Geste ausführenden Körperteils) enthält.

Erfindungsgemäß weist die Sensoreinrichtung eine Verarbeitungseinheit auf, welcher die zeitlichen Signalverläufe zuführbar sind. Dafür sind die Sensoren mit ihren Ausgängen mit der Verarbeitungseinheit gekoppelt. Die Verarbeitungseinheit implementiert wenigstens ein neuronales Netz.

Unter neuronalen Netzen werden in diesem Zusammenhang grundsätzlich künstliche neuronale Netze verstanden. Die Eigenschaften und die Implementierung von neuronalen Netzen sind den entsprechenden Fachkreisen bekannt. Insbesondere wird hier auf die umfangreiche Fachliteratur zu dem Aufbau, den Netztypen, Lernregeln und bekannten Anwendungen von neuronalen Netzen verwiesen.

Neuronale Netze ermöglichen aufgrund Ihrer Netzstruktur, zu bereitgestellten Eingangswerten bzw. Reizen oder Mustern zugehörige Ausgangswerte zu erzeugen. Das Netz ist dabei durch Verbindungen zwischen den Einheiten (Units) bzw. Knoten oder Zellen des Netzes gebildet. Die zu verknüpfenden Einheiten des neuronalen Netzes können, je nach Ausbildung der Netzstruktur bzw. der Verknüpfung, auf andere Einheiten einwirken. Diese Einheiten bzw. Units können in verschiedenen Schichten angeordnet sein. Die Verbindungen zwischen den einzelnen Einheiten werden durch Kanten gebildet, wobei sich ein Einfluss einer Einheit auf eine andere Einheit durch die den Kanten zugeordneten Gewichte ausdrückt. Diese Gewichte, welche die Wechselwirkung der einzelnen Einheiten wesentlich mitbestimmen, speichern das Wissen bzw. die Fähigkeiten eines neuronalen Netzes.

Wird den Eingangs-Einheiten eines solchen Netzes ein Muster zugeführt, propagieren Reize durch das Netz von Einheit zu Einheit entlang der Kanten und lösen jeweils Reaktionen in den jeweiligen Einheiten aus, die von den Zuständen der beteiligten Einheiten abhängen sowie von den Gewichten, welche die Interaktion zwischen den Einheiten bestimmen.

Ist ein derartiges neuronales Netz erst einmal eingerichtet und sind seine Parameter eingestellt, so wird das Netz regelmäßig im Anwendungsfall als eine Art Black-Box verwendet, welche zu einem Eingangsmuster ein weiterverarbeitbares Ausgangsmuster erzeugt. Zu den Parametern eines neuronalen Netzes gehören dabei die bereits genannten Gewichte, wie auch die Aktivitätslevel der Einheiten eines neuronalen Netzes.

Das Netz wird eingerichtet, so dass es für bestimmte Eingangswerte erwartete Antworten erzeugt. Nach der Einrichtung erzeugt das Netz auch für unbekannte Eingangswerte zugehörige Ausgangswerte. Ein Vorteil dieser Art von Signalverarbeitung liegt darin, dass für die Implementierung einer zuverlässigen Auswertung nicht unbedingt eine detaillierte Kenntnis sämtlicher funktionalen Zusammenhänge erforderlich ist.

Die tatsächliche Implementierung findet üblicherweise im Programmcode statt, wobei die Verknüpfungen und erforderlichen Rechenoperationen meist durch Matrizenoperationen nachvollzogen werden, welche durch entsprechende Recheneinrichtungen ausführbar sind.

Um ein solches neuronales Netz an einem jeweiligen Aufgabebereich anzupassen, sind der Fachwelt zahlreiche Ansätze bekannt. Diese werden regelmäßig als Lernregeln für das neuronale Netz bezeichnet. In einem Lernprozess, bei dem die Parameter des neuronalen Netzes eingestellt werden, können grundsätzlich sowohl überwachte Lernvorgänge als auch unüberwachte Lernvorgänge verwendet werden. Bei überwachten Lernvorgängen wird die Antwort eines neuronalen Netzes auf einem Eingangsreiz ausgewertet und ein Feedback an das neuronale Netz gegeben, welches über die Qualität der Netzantwort Rückmeldung gibt. In Abhängigkeit davon werden die Parameter des neuronalen Netzes modifiziert oder optimiert.

Diese Darstellung ist sehr verkürzt und soll lediglich das Verständnis der Anmeldung bei flüchtiger Durchsicht durch Personen erleichtern, die mit diesem Gebiet der Technik nicht vertraut sind. Ein Fachmann an den sich die Anmeldung richtet hat bereits tiefergehendes Verständnis von neuronalen Netzes und entsprechend keinen Bedarf für diese Erläuterungen.

Diese genannten Möglichkeiten neuronaler Netze werden grundsätzlich bei komplexen Aufgabenstellungen eingesetzt. Beispielsweise ist aus der Patentschrift US 7,660,437 B2 ein Verfahren zur Bildauswertung in Kraftfahrzeugen bekannt. Die Bildaufnahme eines Fahrzeuginnenraums wird nach einer entsprechenden Verarbeitung einem neuronalen Netz zugeführt, um beispielsweise Informationen über den Benutzer des Kraftfahrzeuges zu ermitteln. Eine Erkennung von Bewegungsgesten ist mit dieser Einrichtung jedoch nicht möglich.

Es wird deutlich, dass diese Art der Auswertung erfindungsgemäß besondere Vorteile bereithält. Durch die Auswertung von Zeitreihen von wenigstens zwei Sensoren wird eine Fülle von Informationen in die Auswertung einbezogen. Diese Signale werden durch die Ausführung der Geste an sich (also Person des Benutzers, dessen Konstitution und aktuelle Bekleidung und Beladung etc.), sowie die aktuellen Umgebungsbedingungen (Luftfeuchte, Temperatur etc.) beeinflusst. Die Auswertung der Signale bzw. der daraus abgeleiteten Muster mit einem fehlertolerante, da in wesentlichen Zügen statistischen Verfahren erlaubt eine zuverlässigere und sicherere Auswertung als die Anwendung rein deterministischer Methoden.

Gemäß der Erfindung werden die Möglichkeiten des neuronalen Netzes verwendet, um die zeitlichen Signalverläufe von Sensoren zur Erkennung von Bewegungsgesten zu verarbeiten. Im Gegensatz zu einer momentorientierten Bilderkennung kombiniert die Erfindung die vorteile Auswertung von Zeitverläufen mit den Fähigkeiten des neuronalen Netzes.

Die Signal-Zeitverläufe werden entweder direkt als Muster bzw. Reize in ein neuronales Netz eingespeist, oder aus den Signalverläufen werden zuvor geeignete Muster erzeugt. Die Verarbeitungseinheit gibt die Ausgabe des neuronalen Netzes bzw. eine darauf aufbereitete Signalantwort an den Signalausgang der Verarbeitungseinheit aus. Dieser Signalausgang stellt demnach ein Betätigungssignal zur Verfügung, welches abhängig von der Antwort des neuronalen Netzes ist.

Auf welche Weise der zeitliche Signalverlauf dem neuronalen Netz zugeführt wird, ist sowohl von der Auswahl der verwendeten Sensoren als auch von der Art des verwendeten neuronalen Netzes abhängig. Beispielsweise können für ein neuronales Netz mit einer Anzahl von x Eingangs-Einheiten (Input-Units) zeitlich äquidistante Signalwerte oder über einen zugehörigen Zeitabschnitt gemittelte Werte bereitgestellt werden. Alternativ sind beliebige charakteristische Werte der zeitlichen Signalverläufe, beispielsweise Extremwerte, Mittelwerte, Signal-Rauschverhältnisse etc. zu dem neuronalen Netz zuführbar.

Die Auswertung von Signalverläufen von wenigstens zwei Sensoren ist in diesem Fall keineswegs mit einer einfachen Redundanz von Signalen zu vergleichen. Aufgrund der Struktur und Eigenschaften von neuronalen Netzen kann durch die Verwendung von zwei Sensoranordnungen, die räumlich auch nur geringfügig unterschiedliche Erfassungsbereiche aufweisen können, die Erkennungsgenauigkeit drastisch erhöht werden. Durch die Struktur eines entsprechend angepassten neuronalen Netzes wird nämlich das Zusammenspiel der Signalantworten der Sensoren in äußerst differenzierter Weise ausgewertet.

Erfindungsgemäß wird daher die Verwendung von bekannten Sensoren auf eine neue Sensoreinrichtung mit gänzlich neuem Funktionsumfang übertragen.

In einer bevorzugten Ausführungsform der Erfindung sind die Sensoren kapazitive Erfassungssensoren.

Kapazitive Sensoren sind im Bereich der Kraftfahrzeugtechnik seit längerem bewährt und insbesondere zur Erfassung der Annäherung von Bedienern eingesetzt. Das Prinzip dieser Sensoren basiert darauf, dass sich die Kapazität einer Elektrode ändert, wenn der Raumbereich vor der Elektrode teilweise mit einem Körperteil eines Bedieners gefüllt wird. Dann ändern sich das Dielektrikum vor der Elektrode und damit auch die Kapazität der Elektrode. Diese Kapazitätsänderung kann beispielsweise über eine Ladungskontrolle ermittelt werden. Dieses Verfahren ist aus der Sensortechnik bei kapazitiven Türgriffsensoren, z.B. auch aus Anmeldungen der Anmelderin zu dieser Erfindung wohlbekannt.

Gemäß der Erfindung wird ein zeitlicher Ablauf der kapazitiven Veränderung einer Sensorelektrode überwacht. Dieser Signalverlauf wird anschließend dem neuronalen Netz zugeführt. Dieses Konzept hat den Vorteil, dass die grundsätzliche Erfassung mit kapazitiven Elektroden und Sensoren bewährt und etabliert ist und auf vorhandene Strukturen zurückgegriffen werden kann. Die Kombination mit einer zweiten Sensoreinrichtung und die Kombination mit einer Auswertung durch ein neuronales Netz ermöglicht jedoch vollkommen neue Einsatzbereiche, insbesondere die verlässliche Erfassung von Bewegungsgesten. Die Signalverläufe des kapazitiven Sensors können auch zunächst in Muster gewandelt werden, die dann dem neuronalen Netz zugeführt werden. Diese Muster können z.B. Werte zum Signal/Rauschverhältnis, zu Extremwerten, zu Abständen der Extremwerte etc. enthalten. Damit wird die dem Netz zugeführte Datenmenge reduziert, wodurch einfacher strukturierte Netze einsetzbar sind.

In einer Weiterbildung der Erfindung ist der Einsatz von zwei oder mehr kapazitiven Erfassungssensoren bei der erfindungsgemäßen Sensoreinrichtung vorgesehen.

Die zwei oder mehr kapazitiven Erfassungssensoren können an räumlich versetzten Positionen des Kraftfahrzeuges angeordnet werden und weisen dann unterschiedliche Erfassungsbereiche auf. Die Ausführung einer Bewegungsgeste erzeugt in den verschiedenen kapazitiven Sensoreinrichtungen unterschiedliche Signalantworten mit einem unterschiedlichen zeitlichen Verlauf. Wird beispielsweise von dem Benutzer eine Bewegungsgeste mit dem Fuß ausgeführt, kann diese Bewegungsgeste mit einer Bewegung des Fußes im Erfassungsbereich der ersten kapazitiven Sensors beginnen und nach einer Bewegung durch diesen Bereich in einem zweiten Erfassungsbereich eines zweiten Sensors geführt werden. Die dadurch jeweils erzeugten Signalverläufe (oder abgeleitete Muster) werden dem neuronalen Netz zugeführt. Die komplexe Auswertung in dem neuronalen Netz berücksichtigt anhand dieser Signalverläufe sowohl Richtung als auch Tempo der Bewegung sowie auch die Größe und Eigenschaft des bewegten Objekts. Die Sensoreinrichtung weist auf diese Weise mehrere bewährte und preisgünstige Sensoren auf, die jedoch durch die Anordnung und geänderte Auswertung auch Ereignisse erfassen können, die bislang nur deutlich komplexeren Einrichtungen, insbesondere solchen mit Bilderkennung oder bildlicher Bewegungserkennung vorbehalten waren.

Es ist besonders vorteilhaft, wenn die Verarbeitungseinheit eine dem neuronalen Netz vorgeschaltete Aufbereitungsstufe aufweist. Grundsätzlich können die Signale der Sensoren dem neuronalen Netz zwar unaufbereitet zugeführt werden, eine Aufbereitung der Signale ist jedoch regelmäßig für eine Erhöhung der Erkennungsgenauigkeit sinnvoll. Insbesondere können die Sensorsignale normalisiert werden, oder von Störsignalen bereinigt werden. Außerdem können Mittelwertbildungen erfolgen oder charakteristische Werte aus den Signalverläufen extrahiert werden, um diese dem eingangs-einhaltendes neuronalen Netzes als Muster oder Reiz zur Verfügung zu stellen. Die Aufbereitungsstufe kann beispielsweise entlang des Zeitverlaufes über jeweilige Abschnitte Mittelwertbildungen vornehmen, um diese Mittelwerte dem neuronalen Netz zuzuführen. Außerdem können durch eine Vorauswertung charakteristische Kennwerte, z.B. Extremwerte, Umkehrstellen, Signal/Rauschverhältnisse, zeitliche Abstände aus den Signalverläufen extrahiert werden, um anhand dieser Werte eine Auswertung durch das neuronale Netz vornehmen zu lassen.

In einer Weiterbildung der Erfindung werden die Signalverläufe in der Aufbereitungsstufe miteinander verknüpft, um ein Muster zu erzeugen, welches dem neuronalen Netz zugeführt wird. Beispielsweise kann eine Subtraktion normalisierter Signalverläufe von beispielsweise zwei kapazitiven Sensoren ein charakteristisches Muster bilden, anhand dessen das neuronale Netz eine Auswertung vornehmen kann.

Im Rahmen der Aufbereitung der Werte kann auf dieselben Konzepte zurückgegriffen werden, die für eine klassische Auswertung von Sensorsignalen eingesetzt werden. Insbesondere können gängige Algorithmen zur Extremwertbestimmung, Glättung oder Fitting-Algorithmen eingesetzt werden.

In einer weiteren Fortbildung der Erfindung weist die Sensoreinrichtung mehrere neuronale Netze auf. Diese Netze können grundsätzlich nebeneinander, also zur Auswertung einer einzigen Signalantwort verwendet werden, oder alternativ, z.B. wenn für verschiedene identifizierte Benutzer jeweils ein individuelles neuronales Netz verwendet werden soll. Werden mehrere neuronale Netze mit Mustern gespeist, die aus dem zum Betätigungsvorgang gehörenden Signalverlauf stammen, können die Antworten der neuronalen Netze anschießend weiter ausgewertet werden, um das Betätigungssignal zu erzeugen. Regelmäßig ist jedoch die Erhöhung der Komplexität eines neuronalen Netzes sinnvoller, als die parallele Durchführung einer Auswertung mit mehreren neuronalen Netzen. Die Verwendung von mehreren neuronalen Netzen ist jedoch dann sinnvoll, wenn grundsätzlich unterschiedliche Signalantworten zu erwarten sind. Beispielsweise werden unterschiedliche Benutzer eines Kraftfahrzeuges eine Bewegungsgeste in unterschiedlicher Weise ausführen. Zur Erhöhung der Erkennungsgenauigkeit kann jedoch ein auf diesen Benutzer angepasstes neuronales Netzwerk zur Auswertung herangezogen werden. Welches neuronale Netzwerk herangezogen wird, kann aufgrund einer Identifizierung des Benutzers entschieden werden. Wenn der Benutzer beispielsweise einen ID-Geber mit sich führt, kann anhand dieses ID-Gebers gegebenenfalls auf die Person des Benutzers zurückgeschlossen werden. Die Identifizierung kann jedoch auch unterbleiben und eine Auswertung mit allen verfügbaren Netzen erfolgen. Gibt eines der Netze eine im Rahmen vorgegebener Grenzen eindeutige Antwort, kann auch dies als Identifikation dienen.

Das letztgenannte Konzept erlaubt auch den Einsatz der erfindungsgemäßen Sensoreinrichtung und des Verfahrens zu Identifizierung des Benutzers anhand von Betätigungsgesten.

Neben der erfindungsgemäßen Sensoreinrichtung betrifft die Anmeldung auch ein zugehöriges Verfahren zur Auswertung von Sensorsignalen.

Gemäß diesem Verfahren werden Sensorsignale zur Erkennung von Betätigungsgesten ausgewertet. Ein erster kapazitiver Sensor, der zur Erfassung von Objekten an einem ersten Raumbereich am Kraftfahrzeug angeordnet ist, wird abgefragt und eine Folge von Sensorsignalen wird erfasst. Von einem zweiten Sensor, der ebenfalls an Kraftfahrzeug angeordnet ist, wird ebenfalls eine zeitliche Folge von Sensorsignalen erfasst. Beide Signalverläufe werden verarbeitet, wobei aus den zeitlichen Signalverläufen Muster für ein neuronales Netzwerk abgeleitet werden. Die Muster werden in ein neuronales Netz eingespeist und die Antwort des neuronalen Netzes wird abgefragt. Aus der Netzantwort wird ein Bestätigungssignal generiert, welches angibt, ob eine Betätigungsgeste durch den Benutzer ausgeführt wurde oder nicht.

Wesentlich ist, dass auch bei diesem Verfahren mehrere Sensoren und deren zeitliche Verläufe von Sensorsignalen erfasst werden, um Muster für ein neuronales Netzwerk zu bilden. Dementsprechend weist das Verfahren im Wesentlichen die gleichen Vorteile auf, wie oben bereits unter Bezug auf die Sensoranordnung beschrieben wurden.

Es ist möglich, das neuronale Netz anfänglich mit vorgegebenen Parametern einzurichten und in dieser Struktur während des Betriebs des Fahrzeuges beizubehalten. Die Parameter können dazu unter herstellerseitiger Aufsicht durch Lernmethoden bzw. Lernregeln festgelegt werden. Verschiedene charakteristische Benutzergruppen können für das Trainieren der Erkennung von Bewegungsgesten eingesetzt werden. Diese Trainingsphase kann auf einmaliges herstellerseitiges Einlernen des neuronalen Netzes beschränkt werden, wobei dieses üblicherweise charakteristische Parameter für eine Sensoranordnung und ein bestimmtes Fahrzeugmodell ergeben wird. Dieselbe Sensoranordnung, installiert an einem anderen Fahrzeugmodell wird andere Lernparameter für das neuronale Netzwerk zur Folge haben. Eine einzige Sensoranordnung kann auf diese Weise erfindungsgemäß für eine Vielzahl von Kraftfahrzeugen mit hoher Erkennungsgenauigkeit eingesetzt werden, da die Sensorantwort auf Modell und Anordnung trainiert wurde.

Grundsätzlich eröffnet die Erfindung aber auch die Möglichkeit, ein dauerhaft lernfähiges System zur Erfassung von Benutzergesten zu implementieren. Ist in der Sensoranordnung selbst bzw. bei der Anwendung des erfindungsgemäßen Verfahrens vorgesehen, dass die am Kraftfahrzeug installierte Einrichtung ein neuronales Netz enthält, so kann dieses auch als lernfähiges neuronales Netzwerk implementiert sein.

In dieser Alternative bleibt die Lernfähigkeit für das neuronale Netz auch nach Übergang des Fahrzeugs zum Benutzer erhalten. Das neuronale Netz kann auf Anforderung durch den Benutzer in einen Lernmodus versetzt werden, indem das Netz in Abhängigkeit von einem Feedback des Benutzers trainiert wird. Das Lernen des neuronalen Netzwerkes kann mit den bekannten Lernregeln des überwachten Lernens, beispielsweise der Back-Propagation, der Delta-Regel oder der Hebb-Regel Benutzerspezifisch trainiert werden. In diesem Fall kann z.B. das neuronale Netz herstellerseitig mit einem anfänglichen Parametersatz ausgeliefert werden und ein Benutzer kann es gemäß seiner spezifischen Ausführung von Betätigungsgesten trainieren. Zu diesem Zweck wird durch eine Betätigung am Kraftfahrzeug oder z.B. dem ID-Geber an das Kraftfahrzeug signalisiert, dass ein Lernvorgang stattfinden soll. Der Benutzer führt dann, ggf. auf Signalisierung des Kraftfahrzeugs (z.B. Aufleuchten der Rückleuchten oder Blinker) hin, eine Betätigungsgeste aus, die Sensoranordnung erfasst diese und der Benutzer gibt danach an, ob die Betätigungsgeste eine charakteristische Betätigungsgeste für eine gewünschte Betätigung war, oder ob sie ein Ereignis war, welches zukünftig nicht als Betätigungsgeste erkannt werden soll (z.B. wenn er ein Kind die Geste hat ausführen lassen).

Es ist also sowohl Training für positive als auch für negative Signalantworten möglich.

Die Gewichte des neuronalen Netzes werden anschließend gemäß dem Feedback verändert, wobei mit zunehmendem Training eine Verbesserung der Erkennungsgenauigkeit erreicht werden kann. Es besteht für den Benutzer jedoch immer die Möglichkeit, die Parameter des neuronalen Netzes auf die herstellerseitig vorgegebenen Werte zurückzusetzen.

In einer Abwandlung der Erfindung wird eine Sensoranordnung betrieben, wobei die Auswertung der Sensorsignale in klassischer Weise, also über herkömmliche Vergleichsoperationen bzw. klassische Auswerteschritte vorgenommen wird. Die Erkennungsparameter jedoch werden dann erfindungsgemäß auf Herstellerseite mit Hilfe eines neuronalen Netzes bestimmt und optimiert. Die einmal per neuronalem Netz bestimmten Parameter werden anschließend fest in der Auswertelogik der Sensoranordnung implementiert.

Der letztgenannte Fall hat den Vorteil, dass es nicht erforderlich ist, ein neuronales Netz auf Fahrzeug in der Sensoranordnung zu implementieren und so eine kostengünstigere Realisierung der Sensoranordnung möglich ist. Dennoch wird die Erkennungsgenauigkeit durch die Möglichkeiten eines neuronalen Netzes verbessert, da die Erkennungsparameter unter Verwendung des neuronalen Netzes optimiert wurden.

Die Erfindung wird nun anhand der beiliegenden Figuren beispielhaft näher erläutert.

Figur 1a zeigt die Anordnung einer ersten Ausführungsform der erfindungsgemäßen Sensoranordnung an einem Kraftfahrzeug;

Figur 1b zeigt die Anordnung aus Figur 1a in einer schematischen Aufsicht;

In Figur 2 zeigt ein Ablaufschema der Durchführung eines Auswerteverfahrens für ein Sensorsignal der Sensoranordnung aus den Figuren 1a, 1b gemäß der Erfindung gezeigt.

Figur 3 zeigt schematisch die Aufbereitung von Sensorsignalen zur Mustererzeugung für ein neuronales Netz.

Figur 4 zeigt schematisch die Verarbeitung eines aus den Signalen abgeleiteten Musters mit einem neuronalen Netz.

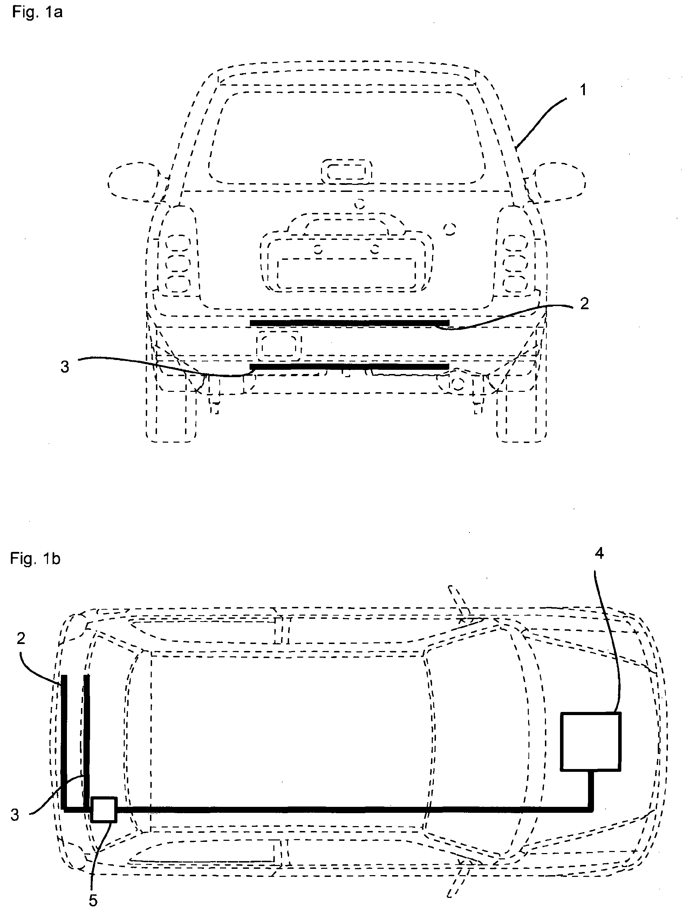

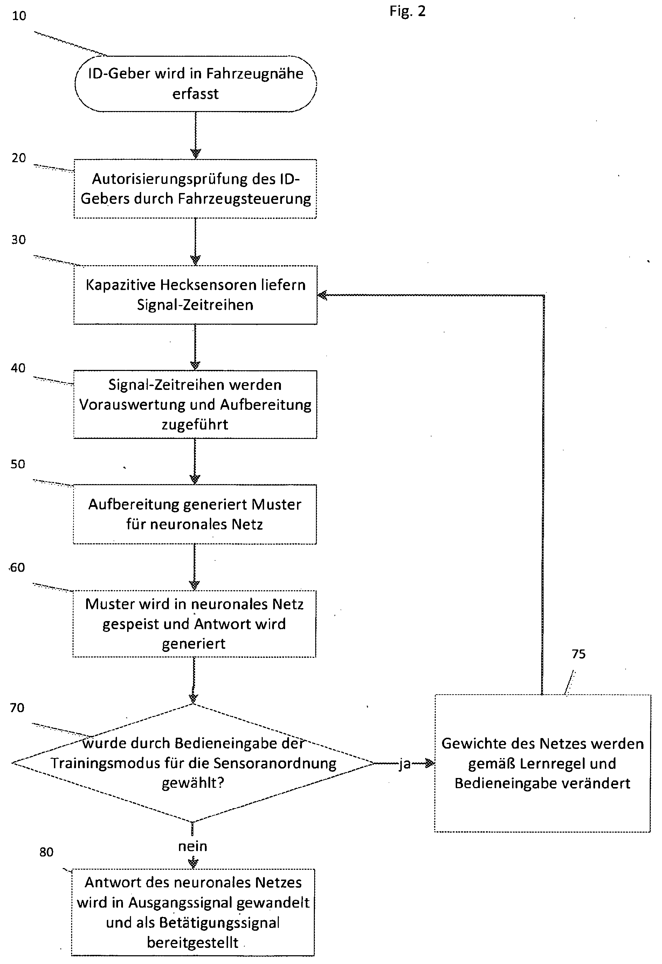

In Figur 1 ist das Heck eines Fahrzeugs 1 gezeigt. Im Bereich des Heckstossfängers ist eine Sensorelektrode 2 angebracht. Unterhalb der Sensorelektrode 2 ist eine weitere Sensorelektrode 3 angeordnet. Die Sensorelektroden 2 und 3 sind jeweils mit der Steuer- und Auswerteeinrichtung 5 verbunden. Eine Fahrzeugsteuereinheit 4 ist an beliebigem anderen Ort im Fahrzeug angeordnet (siehe Figur 2).

Die Elektroden werden über die zugehörige Steuer-/Auswerteeinrichtung 5 aufgeladen und die Kapazitätsänderung der Elektroden bei Annäherung eines Körpers, z.B. eines Bedienerkörperteils, kann durch Ladungsauswertung erfasst werden. Dieses Prinzip eines kapazitiven Sensors ist im Bereich der Kraftfahrzeugtechnik bekannt.

Die Sensorelektrodenanordnung 3 verläuft in diesem Beispiel im Wesentlichen parallel zu der Elektrode 2.

Bei einem Bedienwunsch kann ein hinter dem Fahrzeug stehender Bediener bspw. seinen Unterschenkel in einer Schwenkbewegung unter den Stoßfänger bewegen. Diese Bewegung und Annäherung wird sowohl durch die Elektrodenanordnung 2 erfasst, als auch durch die Sensorelektrode 3, da die Kapazitätsänderung wiederholt abgefragt und die Veränderung der Kapazität ausgewertet wird.

Ein tatsächliches Öffnungskommando wird nur von der zentralen Steuereinrichtung 4 generiert. Dieser Steuereinrichtung 4 liefert die Steuer-/Auswerteeinrichtung 5 eine entsprechendes Bediensignal, das unter Verwendung eines neuronalen Netzes erzeugt wird. Ob tatsächliche eine Öffnung ausgelöst wird, bestimmt die Steuereinrichtung 4 in Abhängigkeit von diesem Signal und weiteren Parametern (Stillstand des Fahrzeugs etc.).

In Figur 2 ist anhand eines Ablaufschemas gezeigt, wie eine typische Signalerkennung bei der Ausführung einer Betätigungsgeste durch einen Benutzer abläuft.

In Schritt 10 wird fahrzeugseitig erfasst, dass sich ein Benutzer mit einem ID-Geber dem Fahrzeug nähert. Der Ablauf einer solchen Erfassung ist aus Verfahren zur schlüssellosen Zugangskontrolle für Fahrzeugbenutzer (Keyless-Entry) hinlänglich bekannt. Wird die Annäherung erfasst, wird (ebenfalls nach bekannten Verfahren) die Autorisierung des ID-Gebers zum Zugriff auf das Kraftfahrzeug verifiziert, indem eine drahtlose Kommunikation zwischen Fahrzeug und ID-Geber ausgeführt wird.

In diesem genannten Beispiel betreffen die auszuwertenden Sensoren kapazitive Sensoren, die im Bereich des Fahrzeughecks zur Betätigungskontrolle für die Heckklappe eingesetzt sind.

Die kapazitiven Hecksensoren sind als längliche Elektroden im Heck des Fahrzeuges an versetzten Positionen angeordnet. Beispielsweise ist einer dieser Sensoren entlang des Stoßfängers des Kraftfahrzeuges angeordnet, während ein zweiter Sensor unterhalb des Fahrzeuges, also sowohl in der Höhe als auch der Tiefe des Fahrzeuges in Richtung Fahrgastraum versetzt angeordnet ist.

Die kapazitiven Hecksensoren liefern in Abhängigkeit von der Bewegung der Beine eines Benutzers, welcher sich hinter dem Heck des Fahrzeugs aufhält, charakteristische Signale. Dazu werden die kapazitiven Hecksensoren z.B. in rascher Folge aufgeladen bzw. entladen, um Rückschlüsse auf die Kapazität des jeweiligen Sensors ziehen zu können. Bewegt sich das Bein des Benutzers beispielsweise in einer charakteristischen Bewegung unterhalb des Kraftfahrzeughecks, z.B. einer Tritt- bzw. Kickbewegung, so liefern die Hecksensoren entsprechende Zeitverläufe in ihren Signalen. Das Bein und der Fuß des Benutzers verändern das Dielektrikum in dem sensierten Bereich der kapazitiven Sensoren und damit auch die Kapazität des jeweiligen Sensors.

Die Signale der Sensoren werden kontinuierlich überwacht, und aus den Signalen kann ein Trigger für den Beginn des vollständigen Auswerteverfahrens generiert werden. Beispielsweise kann vorgesehen sein, dass bei Überschreiten eines bestimmten Signal/Rauschverhältnisses ein Auswertungsdurchlauf ausgelöst wird. Die aufgezeichneten Signalverläufe erfassen einen Zeitraum, der ausreicht, um eine Betätigungsgeste auszuführen.

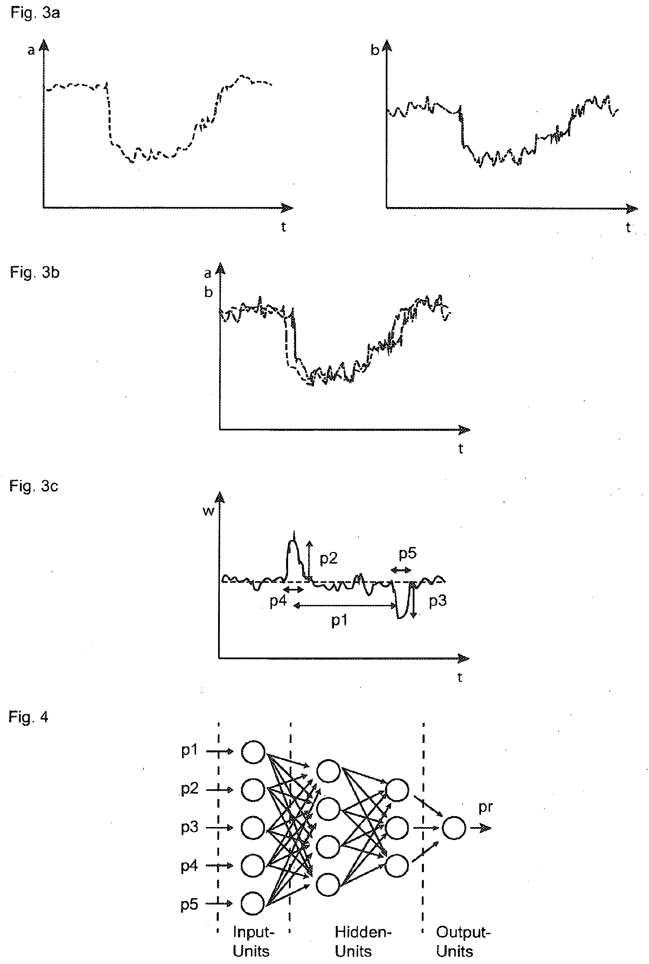

Figur 3a zeigt zwei beispielhafte Verläufe einer Sensorantwort einer kapazitiven Elektrode a über die Zeit und einer kapazitiven Elektrode b über die Zeit. Der Signalverlauf, insbesondere der starke Signalausschlag und die allmähliche Rückkehr zu dem Ausgangswert zeigen an, dass sich im Bereich der Sensoren das Dielektrikum verändert hat, was in einer Kapazitätsänderung der Sensorelektroden resultiert. Es ist zu diesem Zeitpunkt jedoch nicht klar, ob diese Veränderung auf eine bewusst ausgeführte Betätigungsgeste zurückzuführen ist oder ob es sich um ein zufälliges oder ohne Motivation ausgeführtes Ereignis handelt (z.B. ein unter dem Fahrzeug rollenden Ball oder eine unter dem abgestellten Fahrzeug herlaufende Katze).

In dem Ablauf aus Figur 2 wird bei Schritt 40 eine Vorauswertung und Aufbereitung der zeitlichen Sensordaten ausgeführt.

Dies ist in Figur 3b dargestellt, in welcher die Signalverläufe einerseits normalisiert und zeitsynchron überlagert wurden. Diese Darstellung zeigt, dass die Sensorsignale verschobene Zeitkomponenten aufweisen und sich auch sonst, trotz Normalisierung, charakteristisch unterscheiden.

Wie in Figur 2 bei Schritt 50 gezeigt, werden anschließend Muster aus den aufbereiteten Signalverläufen für das neuronale Netz generiert. Dazu wird in diesem Ausführungsbeispiel eine Verknüpfung der Signalverläufe a und b vorgenommen.

In Figur 3c ist ein Signalverlauf gezeigt, der durch Subtraktion des Signalverlaufs a von dem Signalverlauf b generiert wurde. Diese resultierende Signalzeitreihe enthält noch wesentliche Informationen der ursprünglichen einzelnen Zeitreihen, ist jedoch leichter weiter aufzubereiten. Für die Aufbereitung werden aus dem kombinierten Signalverlauf Muster für die Zuführung zum neuronalen Netz extrahiert.

Dieser Vorgang ist beispielhaft in Figur 3c dargestellt, wo charakteristische Werte p1, p2, p3, p4 und p5 aus dem aufbereiteten Signal abgeleitet werden. Diese abgeleiteten Werte enthalten Informationen über die ausgeführte Bewegungsgeste aus beiden Sensoren, da sie durch Aufbereitung beider Sensorsignalverläufe generiert wurden.

Beispielsweise liefern die kapazitiven Sensoren dann Extremwerte in ihren Kapazitätssignalen, wenn sich der Fuß des Benutzers bzw. dessen Bein im Bereich der höchsten Annäherung oder größten Raumfüllung befindet. Die Größe der Differenzsignale zwischen den Sensoranordnungen und der zeitliche Verlauf können als Muster für die Einspeisung in ein neuronales Netz verwendet werden.

Es ist klarzustellen, dass die dargestellte und skizzierte Ausführungsweise lediglich eine beispielhafte Auswertung für die Möglichkeiten der Erfindung ist. Grundsätzlich können auch Signalverläufe selbst oder gänzlich andere daraus abgeleitete Parameter einem neuronalen Netz zugeführt werden. Zum besseren Verständnis ist hier jedoch eine beispielhafte und leicht nachvollziehbare Herangehensweise gezeigt.

Der Mustervektor p1,...,p5 wird dem neuronalen Netz zugeführt, wie in Schritt 60 der Figur 2 gezeigt. Dies ist schematisch auch in Figur 4 dargestellt, wo den Input-Units (Eingangs-Einheiten) die Werte eingespeist werden. Das neuronale Netz generiert in Abhängigkeit von seinem Aufbau und insbesondere seinen Vernetzungen und Gewichten eine Antwort. Entlang der Kanten propagieren Reize von den Eingangs-Einheiten (Input-Units) über die verdeckten Einheiten (Hidden-Units) des Netzes bis zu den Ausgangs-Einheiten (Output-Units). Die an den Ausgangs-Einheiten bereitgestellten Werte entsprechen den Ausgabewerten des neuronalen Netzes, also der Netzantwort.

In Schritt 70 der Figur 2 wird geprüft, ob durch den Benutzer die Ausführung des Trainingsmodus für die Sensoranordnung gewählt wurde. Im üblichen Erfassungsmodus und alltäglichen Gebrauch wird diese Frage mit Nein zu beantworten sein, so dass aus der Antwort des neuronalen Netzes bei Schritt 80 ein Ausgangssignal erzeugt wird, welches dem Kraftfahrzeug als Betätigungssignal bereitgestellt wird. Dafür kann die Antwort mit einem Wertebereich verglichen werden, welcher eine positive Antwort, also das Vorliegen einer Betätigungsgeste signalisiert. Die zentrale Steuereinrichtung des Kraftfahrzeuges kann in Abhängigkeit von diesem Betätigungssignal die Öffnung der Heckklappe freigeben oder sperren.

Falls jedoch der Benutzer den Trainingsmodus für die Sensoranordnung am Kraftfahrzeug initiiert hat, so wird vom Benutzer nun die Eingabe erwartet, ob das eingetretene Ereignis eine charakteristische Bedienangabe bzw. Bediengeste war. Wird dies bejaht, so wird dieses Feedback zusammen mit der Ausgabe des neuronalen Netzes benutzt, um das neuronale Netz im Lernmodus zu verbessern, also die Parameter und Gewichte des neuronalen Netzes in Abhängigkeit vom Feedback anzupassen. Hat beispielsweise der Benutzer mehrmals eine gezielt ausgeführte Betätigungsgeste trainiert, so kann er anschließend auch eine typische Simulation eines Alltagsereignisses vornehmen, welches explizit keine Bediengeste darstellen soll. Er kann beispielsweise einen Ball unter das Fahrzeug rollen oder ein Kind die Bediengeste ausführen lassen. Das neuronale Netz lernt dann anhand der erfassten Muster die verschiedenen Ereignisse besser zu differenzieren.

In gleicher Weise können benutzerspezifische neuronale Netze trainiert werden, wenn z.B. fahrzeugseitig für jeden Benutzer des Kraftfahrzeuges ein eigener Aufbau des neuronalen Netzes und dessen Gewichtung gespeichert sein soll.

Die Erfindung ist selbstverständlich auch mit neuronalen Netzen einsetzbar, die nicht als lernfähig ausgelegt sind. Diese neuronalen Netze können beispielsweise herstellerseitig oder werkstattseitig trainiert werden, wonach die entsprechenden Lernwerte des neuronalen Netzwerkes, d. h. seine Parameter gespeichert werden. Auch dort bietet die Erfindung wesentliche Vorteile, da eine Sensoranordnung verwendet werden kann, die in Abhängigkeit von ihrer Montageposition am Fahrzeug und dem Fahrzeugtyp sensibilisiert und abgestimmt werden kann, ohne bauliche Änderungen vorzunehmen. Dieselbe Sensoreinrichtung würde dann in einem Kleinwagen gänzlich andere Lernwerte als in einer größeren Limousine aufweisen. Auch die Sicherheit der Erkennung und der Komfort für den Benutzer werden dadurch deutlich erhöht.

Auch wenn die Erfindung anhand der Signalanordnung von kapazitiven Sensoren beschrieben wurden, können für die Erfindung nahezu beliebige Arten von Sensoren verwendet werden. Beispielsweise können auch die Signale von ohnehin bereits vorhandenen Sensoren, z.B. Abstandssensoren in die Auswertung einbezogen werden. Wesentlich ist, dass eine Mehrzahl von Sensoren verwendet wird, um die Sicherheit der Einrichtung zu erhöhen. Außerdem ist die Erfindung hinsichtlich ihrer Verwendung der Sensorsignale und der Aufbereitung vor der Einspeisung in das neuronale Netz in keiner Weise limitiert. Je nach Leistungsfähigkeit des neuronalen Netzes können umfangreiche Vektoren in das Netz eingespeist werden, oder die Auswertung mit dem neuronalen Netz wird mit einer klassischen Aufbereitungsstufe kombiniert, um eine reduzierte Anzahl von Musterwerten zu erhalten, wie dies im Beispiel beschrieben wurde. Je nach Leistungsfähigkeit des neuronalen Netzes ist es dann sogar möglich, dem Benutzer die Möglichkeit zum Eintrainieren gänzlich individueller Bedienungsgesten zu geben. Der Benutzer ist in diesem Fall noch nicht einmal auf die Ausführung einer vorgesehenen Bewegung (z.B. eines angedeuteten Kicks in Richtung des Kraftfahrzeuges) beschränkt. Auf diese Weise könnte der Sensoranordnung sogar soviel Flexibilität zugeordnet werden, dass ein benutzerseitiger Lernvorgang auch gänzlich neue Bewegungsabläufe erlernen könnte.

Wie oben beschrieben, ist die Erfindung jedoch nicht nur auf Verfahren beschränkt, welche ein neuronales Netz im Kraftfahrzeug selbst verwenden. Vielmehr kann grundsätzlich auch ein neuronales Netz auf Herstellerseite eingesetzt werden, um Auswerte- oder Vergleichsparameter für einen klassischen Auswertevorgang zu finden und zu optimieren. Der oben dargestellte Ablauf würde dann im Wesentlichen gleich ablaufen, die in Figur 3C ermittelten charakteristischen Musterwerte würden z.B. jedoch einer klassischen Vergleichsauswertung zugeführt. Die Vergleichswerte und Intervalle für diese Auswertung sind jedoch herstellerseitig durch ein neuronales Netz festgelegt, welches die spezifischen Eigenschaften eines Fahrzeuges und die Anordnung der Sensoren am Fahrzeug berücksichtigt. Auf diese Weise wäre natürlich die Lernfähigkeit des neuronalen Netzes nach erstmaliger Installation nicht mehr vorhanden.

## Patentansprüche

1. Sensoreinrichtung zur Erfassung von Betätigungsgesten eines Benutzers von einem Kraftfahrzeug (1),
wobei ein erster kapazitiver Sensor (2) zur Erfassung von Objekten in einem ersten Raumbereich vorgesehen ist und wenigstens ein weiterer kapazitiver Sensor (3) zur Erfassung von Objekten in einem weiteren Raumbereich vorgesehen ist,
die Sensoren Ausgänge zum Abgriff von zeitlichen Signalverläufen aufweisen,
**dadurch gekennzeichnet, dass**
die Ausgänge der Sensoren mit einer Verarbeitungseinheit (5) gekoppelt sind, wobei
die Verarbeitungseinheit (5) ein neuronales Netz implementiert, welchem die zeitlichen Signalverläufe oder aus den zeitlichen Signalverläufen abgeleitete Muster zuführbar sind, wobei
die Verarbeitungseinheit einen mit den Ausgabe-Einheiten des neuronalen Netzes gekoppelten Signalausgang aufweist, welcher zur Abfrage eines Betätigungssignals abfragbar ist.

2. Sensoreinrichtung nach Anspruch 1, wobei die Sensoreinrichtung drei oder mehr kapazitive Erfassungssensoren aufweist.

3. Sensoreinrichtung nach einem der vorangehenden Ansprüche, wobei die Verarbeitungseinheit eine dem neuronalen Netz vorgeschaltete Aufbereitungsstufe enthält, welche die Sensorsignale vor der Zuführung zu dem neuronalen Netz durch arithmetische Operationen verändert.

4. Sensoreinrichtung nach Anspruch 3, wobei die Aufbereitungsstufe die Signale der Sensoren zu einem Eingangsmuster für das neuronale Netz verknüpft.

5. Sensoranordnung nach einem der vorstehenden Ansprüche, wobei die Verarbeitungseinheit mehrere neuronale Netze aufweist, welchen jeweils aus den Signalverläufen abgeleitete Muster zuführbar sind, wobei die Ausgaben der neuronalen Netze zur Bereitstellung des Betätigungssignals in der Verarbeitungseinheit verknüpfbar sind.

6. Sensoranordnung nach einem der vorstehenden Ansprüche, wobei die Verarbeitungseinheit einen Signaleingang aufweist, über welchen ein Rückmeldesignal an die Verarbeitungseinheit zuführbar ist, wobei die Verarbeitungseinheit derart ausgebildet ist, dass in Abhängigkeit von dem Rückmeldesignal die Gewichte des neuronalen Netzes veränderbar sind.

7. Verfahren zum Auswerten von Sensorsignalen zur Erkennung von Betätigungsgesten eines Benutzers von einem Kraftfahrzeug (1),
wobei ein erster kapazitiver Sensor (2) zur Erfassung von Objekten in einem ersten Raumbereich am Kraftfahrzeug vorgesehen wird und wenigstens ein weiterer kapazitiver Sensor (3) zur Erfassung von Objekten in einem weiteren Raumbereich vorgesehen wird,
jeweils ein zeitlicher Signalverlauf der Sensoren abgegriffen und einer Verarbeitungseinheit zugeführt wird (40),
aus den zeitlichen Signalverläufen Muster abgeleitet werden (50),
**dadurch gekennzeichnet, dass**
die Muster den Eingangs-Einheiten eines neuronalen Netzes zugeleitet werden,
in dem neuronalen Netz eine Netzantwort aus den Mustern generiert wird, wobei die Ausgangs-Einheiten des neuronalen Netzes die Netzantwort bereitstellen (60),
die Netzantwort zu einem Betätigungssignal gewandelt wird, welches angibt, ob eine Betätigungsgeste durch den Benutzer ausgeführt wurde (80).

8. Verfahren nach Anspruch 7, wobei die zeitlichen Signalverläufe von mehreren Sensoren zu wenigstens einem Muster verknüpft werden, welches den Eingangs-Einheiten des neuronalen Netzes zugeführt wird.

9. Verfahren nach Anspruch 7 oder 8, wobei ein zeitlicher Ladungszustandsverlauf des kapazitiven Sensors als Sensorsignal verwendet wird.

10. Verfahren nach einem der Ansprüche 7 bis 9, wobei mehrere neuronale Netze verwendet werden, wobei jedes der neuronalen Netze mit Mustern gespeist wird, die von wenigstens einem der zeitlichen Signalverläufe der Sensoren abgeleitet werden.

11. Verfahren nach einem der Ansprüche 7 bis 10, wobei nach Bereitstellung des Betätigungssignals ein Rückmeldungssignal an die Verarbeitungseinheit übermittelt wird und in Abhängigkeit von dem Rückmeldungssignal eine Veränderung der Gewichte des neuronalen Netzes vorgenommen wird.

12. Verfahren nach einem der Ansprüche 7 oder 8, wobei mehrere neuronale Netze verwendet werden, von denen in Abhängigkeit von einer Identifikation des Benutzers eines als aktives neuronales Netz für die Signalauswertung ausgewählt wird.

13. Verfahren nach einem der Ansprüche 7 bis 12, wobei aus den Signalverläufen zunächst charakteristische Kennwerte abgeleitet werden, wobei diese charakteristischen Kennwerte dem neuronalen Netz als Muster zugeführt werden.

## Claims

1. A sensor device for detecting a motor vehicle (1) user's actuating gestures,
wherein a first capacitive sensor (2) is provided for detecting objects in a first spatial area and at least one further capacitive sensor (3) is provided for detecting objects in a further spatial area,
the sensors have outputs for the pickup of chronological signal progressions,
**characterised in that**
the sensors' outputs are coupled to a processing unit (5), wherein
the processing unit (5) implements a neural network into which the chronological signal progressions, or patterns derived from the chronological signal progressions, can be fed, wherein
the processing unit comprises a signal output which is coupled to the output units of the neural network and which can be polled in order to request an actuating signal.

2. The sensor device according to claim 1, wherein the sensor device has three or more capacitive detection sensors.

3. The sensor device according to one of the preceding claims, wherein the processing unit includes a preparatory stage upstream of the neural network, which modifies the sensor signal through arithmetic operations before it is fed into the neural network.

4. The sensor device according to claim 3, wherein the preparatory stage links the signals of the sensors to form an input pattern for the neural network.

5. The sensor device according to one of the preceding claims, wherein the processing unit has a number of neural networks, into each of which the patterns derived from the signal progressions can be fed, wherein the outputs from the neural networks can be linked in the processing unit in order to provide the actuating signal.

6. The sensor device according to one of the preceding claims, wherein the processing unit has a signal input, via which a feedback signal can be fed into the processing unit, wherein the processing unit is designed such that the weights of the neural networks can be modified in dependence of the feedback signal.

7. A method for evaluating sensor signals in order to recognise a motor vehicle (1) user's actuating gestures, wherein
a first capacitive sensor (2) is provided for detecting objects in a first spatial area in a motor vehicle and at least one further capacitive sensor (3) is provided for detecting objects in a further spatial area,
a chronological signal progression of the sensors is picked up in each case and fed into a processing unit (40),
patterns are derived from the chronological signal progressions (50),
**characterised in that**
the patterns are passed to the input units of a neural network,
a network response is generated in the neural network from the patterns, wherein the output units of the neural network provide the network response (60),
the network response is converted into an actuating signal, which indicates whether an actuating gesture was performed by the user (80).

8. The method according to claim 7, wherein the chronological signal progressions of a number of sensors are linked to form at least one pattern which is fed to the input units of the neural network.

9. The method according to claim 7 or 8, wherein a chronological charge-state progression of the capacitive sensor is used as a sensor signal.

10. The method according to one of claims 7 to 9, wherein a number of neural networks are used, wherein each of the neural networks is supplied with patterns which are derived from at least one of the chronological signal progressions of the sensors.

11. The method according to one of claims 7 to 10, wherein upon providing the actuating signal a feedback signal is transmitted to the processing unit and a modification of the weights of the neural networks is performed in dependence of the feedback signal.

12. The method according to one of claims 7 or 8, wherein a number of neural networks are used, of which one is selected as the active neural network for signal evaluation in dependence of an identification of the user.

13. The method according to one of claims 7 to 12, wherein initially characteristic values are derived from the signal progressions, wherein the said characteristic values are fed as patterns to the neural network.

## Revendications

1. Dispositif de détection pour la saisie de gestes de commande d'un utilisateur d'un véhicule (1),
pour lequel un premier détecteur capacitif (2) est prévu pour la saisie d'objets dans une première zone d'espace et au moins un autre détecteur capacitif (3) est prévu pour la saisie d'objets dans une autre zone d'espace,
les détecteurs comportent des sorties pour capter les variations des signaux dans le temps,
**caractérisé en ce que**
les sorties des détecteurs sont couplées avec une unité de traitement (5), pour lequel
l'unité de traitement (5) met en oeuvre un réseau neuronal auquel les variations des signaux dans le temps ou les modèles dérivés des variations des signaux dans le temps peuvent être acheminés
pour lequel
l'unité de traitement comporte une sortie de signaux couplée aux unités de sortie du réseau neuronal, laquelle peut être interrogée pour l'interrogation d'un signal de commande.

2. Dispositif de détection selon la revendication 1 pour lequel le dispositif de détection comporte trois détecteurs de saisie capacitifs, ou plus.

3. Dispositif de détection selon l'une quelconque des revendications précédentes pour lequel l'unité de traitement contient un étage de prétraitement monté en amont du réseau neuronal, lequel modifie les signaux de détecteur par des opérations arythmétiques avant l'acheminement au réseau neuronal.

4. Dispositif de détection selon la revendication 3, pour lequel l'étage de prétraitement relie les signaux des détecteurs à un modèle d'entrée pour le réseau neuronal.

5. Agencement de détection selon l'une quelconque des revendications précédentes, pour lequel l'unité de traitement comporte plusieurs réseaux neuronaux, lesquels peuvent être acheminés respectivement depuis les modèles dérivés des variations des signaux, pour lequel les sorties des réseaux neuronaux peuvent être reliées à l'unité de traitement pour fournir le signal de commande.

6. Dispositif de détection selon l'une quelconque des revendications précédentes, pour lequel l'unité de traitement comporte une entrée de signaux par laquelle un signal en retour peut être acheminé à l'unité de traitement, l'unité de traitement étant constituée de telle manière que les poids du réseau neuronal peuvent être modifiés en fonction du signal en retour.

7. Procédé destiné à l'évaluation de signaux de détection pour identifier des gestes de commande d'un utilisateur d'un véhicule (1),
pour lequel un premier détecteur capacitif (2) est prévu sur le véhicule pour la saisie d'objets dans une première zone d'espace et au moins un autre détecteur capacitif (3) est prévu pour la saisie d'objets dans une autre zone d'espace,
une variation des signaux dans le temps des détecteurs est respectivement prélevée et acheminée à une unité de traitement (40),
des modèles sont dérivés (50) des variations des signaux dans le temps,
**caractérisé en ce que**
les modèles sont dirigés vers les unités d'entrée d'un réseau neuronal,
dans le réseau neuronal, une réponse de réseau est générée à partir des modèles, les unités de sortie du réseau neuronal fournissant la réponse de réseau (60),
la réponse de réseau est convertie en un signal de commande, lequel indique si un geste de commande a été exécuté (80) par l'utilisateur (80).

8. Procédé selon la revendication 7, pour lequel les variations des signaux dans le temps de plusieurs détecteurs sont reliées à au moins un modèle, lequel est acheminé aux unités d'entrée du réseau neuronal.

9. Procédé selon la revendication 7 ou 8, pour lequel l'allure de l'état de charge du détecteur capacitif est utilisée comme signal de détection.

10. Procédé selon l'une quelconque des revendications 7 à 9, pour lequel plusieurs réseaux neuronaux sont utilisés, chacun des réseaux neuronaux étant alimenté par des modèles, qui sont dérivés d'au moins une des variations des signaux dans le temps des détecteurs.

11. Procédé selon l'une quelconque des revendications 7 à 10, pour lequel un signal en retour est transmis à l'unité de traitement après fourniture du signal de commande et une modification des poids du réseau neuronal est pratiquée en fonction du signal en retour.

12. Procédé selon l'une quelconque des revendications 7 ou 8, pour lequel plusieurs réseaux neuronaux sont utilisés parmi lesquels l'un est sélectionné en tant que réseau neuronal actif pour l'évaluation des signaux en fonction d'une identification de l'utilisateur.

13. Procédé selon l'une quelconque des revendications 7 à 12, pour lequel des valeurs caractéristiques sont d'abord dérivées des variations des signaux, ces valeurs caractéristiques étant acheminées au réseau neuronal en tant que modèles.
